# EUROPÄISCHE PATENTSCHRIFT

(11) **EP 1 321 967 B1**
(45) Veröffentlichungstag und Bekanntmachung des Hinweises auf die Patenterteilung: **03.11.2004**
(21) Anmeldenummer: 01204781.7
(22) Anmeldetag: 05.12.2001
(51) Int. Cl.: H01L 21/00, H05K 13/04

(54) **Einrichtung für die Montage von Halbleiterchips**
Apparatus for mounting semiconductor chips
Dispositif de montage de puces semiconductrices

(43) Veröffentlichungstag der Anmeldung: 25.06.2003
(73) Patentinhaber: Esec Trading S.A., 6330 Cham (CH)
(72) Erfinder: Hartmann, Dominik, 6332 Hagendorn (CH)
(74) Vertreter: Falk, Urs, Dr.

(56) Entgegenhaltungen:
- US-A- 5 351 872
- PATENT ABSTRACTS OF JAPAN vol. 013, no. 235 (E-766), 30. Mai 1989 (1989-05-30) -& JP 01 041230 A (MITSUBISHI ELECTRIC CORP), 13. Februar 1989 (1989-02-13)
- PATENT ABSTRACTS OF JAPAN vol. 1997, no. 04, 30. April 1997 (1997-04-30) -& JP 08 330790 A (NEC CORP), 13. Dezember 1996 (1996-12-13)
- PATENT ABSTRACTS OF JAPAN vol. 1998, no. 13, 30. November 1998 (1998-11-30) -& JP 10 209687 A (YAMAHA MOTOR CO LTD), 7. August 1998 (1998-08-07)
- PATENT ABSTRACTS OF JAPAN vol. 1999, no. 03, 31. März 1999 (1999-03-31) -& JP 10 340931 A (TORAY ENG CO LTD), 22. Dezember 1998 (1998-12-22)
- PATENT ABSTRACTS OF JAPAN vol. 1999, no. 14, 22. Dezember 1999 (1999-12-22) -& JP 11 260840 A (MATSUSHITA ELECTRIC IND CO LTD), 24. September 1999 (1999-09-24)

## Beschreibung

Die Erfindung betrifft eine Einrichtung für die Montage von Halbleiterchips der im Oberbegriff des Anspruchs 1 genannten Art.

Solche Montageautomaten werden auch als Die Bonder bezeichnet. Ein Die Bonder umfasst eine als Pick and Place System bezeichnete Einrichtung, welche einen Bondkopf mit einem Chipgreifer umfasst, um die zahlreichen, gleichartigen Halbleiterchips eines Wafers, die sich nebeneinander auf einer Trägerfolie befinden, nacheinander auf einem Substrat, z.B. einem metallischen Leadframe, zu montieren. Aus der europäischen Patentanmeldung EP 923 111 ist ein Pick and Place System bekannt, bei dem der Bondkopf mit hoher Geschwindigkeit zwischen zwei festen Endlagen hin und her geführt wird. Der Bondkopf gleitet auf einem Rahmen. Der Chipgreifer ist gegenüber dem Bondkopf in vertikaler Richtung verschiebbar gelagert. Zum Aufnehmen des Halbleiterchips wird der Rahmen abgesenkt. Sobald der Chipgreifer auf den Halbleiterchip auftrifft, wird er gegenüber dem Bondkopf ausgelenkt, wobei der Auslenkung eine zwischen dem Chipgreifer und dem Bondkopf eingespannte Feder entgegenwirkt. Auch zum Plazieren des Halbleiterchips auf dem Substrat wird der Rahmen abgesenkt.

Aus der europäischen Patentanmeldung EP 1 143 487 ist eine als Pick and Place System geeignete Linearführung bekannt, bei dem der Bondkopf zwischen zwei beliebigen Endlagen hin und her geführt werden kann.

JP-01 041 230 beschreibt eine Einrichtung für die Montage von Halbleiterchips, mit einem Pick and Place System, bei dem der Bondkopf einen durch eine Druckkammer gebildetenpneumatischen Antrieb für die Ausleukung des Chipgreifers aufweist.

An den Montageprozess werden zwei Anforderungen gestellt, die mit den heutigen Systemen nur mit grossem Aufwand erfüllt werden können. Beim Aufnehmen des Halbleiterchips soll das Absenken des Bondkopfs bzw. des Chipgreifers in möglichst kurzer Zeit erfolgen. Der Chipgreifer darf aber nicht mit zu grosser Geschwindigkeit auf den Halbleiterchip aufprallen, da sonst der Halbleiterchip beim Aufprall beschädigt oder sogar zerstört wird. Auch beim Plazieren des Halbleiterchips auf dem Substrat soll das Absenken in möglichst kurzer Zeit erfolgen. Zusätzlich soll der Chipgreifer eine vorbestimmte Bondkraft aufbringen, mit der der Halbleiterchip gegen die auf dem Substrat aufgebrachte Klebstoffportion gedrückt wird. Während diese Bondkraft bei kleinen Halbleiterchips in der Regel relativ gering ist, werden bei der Verarbeitung grosser Halbleiterchips relativ grosse Bondkräfte verlangt. Die Bondkraft bestimmt sich durch den Grad der Auslenkung der zwischen dem Chipgreifer und dem Bondkopf eingespannten Feder. Damit das Aufnehmen des Halbleiterchips mit grosser Absenkgeschwindigkeit des Chipgreifers erfolgen kann, muss die Feder relativ weich sein, um den Aufprall ausreichend gering zu halten. Damit bei grossen Halbleiterchips die erforderliche Bondkraft aufgebracht werden kann, muss die Feder aber relativ steif sein, da sonst die zum Aufbringen der Bondkraft nötige Auslenkung zu gross wird.

Der Erfindung liegt die Aufgabe zugrunde, ein Pick and Place System zu entwickeln, das sowohl ein schnelles Absenken des Chipgreifers ermöglicht als auch eine grosse Bondkraft aufbringen kann.

Die Erfindung besteht in den im Anspruch 1 angegebenen Merkmalen. Vorteilhafte Ausgestaltungen ergeben sich aus den abhängigen Ansprüchen.

Eine erfindungsgemässe Einrichtung für die Montage von Halbleiterchips weist ein in vertikaler Richtung stationär angeordnetes Pick and Place System für die Aufnahme, den Transport und das Absetzen eines Halbleiterchips auf einem Substrat auf. Das Pick and Place System umfasst einen Bondkopf mit einem gegenüber dem Bondkopf auslenkbaren Chipgreifer. Die Auslenkung des Chipgreifers erfolgt mittels eines auf dem Bondkopf angeordneten, pneumatischen Antriebes, der zwei durch einen Kolben getrennte Druckkammern aufweist, wobei der Chipgreifer am Kolben befestigt ist. Der in der ersten Druckkammer herrschende Druck p₁ und der in der zweiten Druckkammer herrschende Druck p₂ werden mittels eines von einem Regler gesteuerten Ventilsystems dynamisch geregelt. Der Regler ist in zwei Betriebsarten betreibbar. In der ersten Betriebsart wird die Auslenkung des Chipgreifers und/oder eine davon abgeleitete Grösse aufgrund des von einem Wegaufnehmer gelieferten Signals geregelt, der die Auslenkung des Chipgreifers misst. In der zweiten Betriebsart wird der Druck p₁ und/oder der Druck p₂ und/oder die Druckdifferenz p₁-p₂ geregelt.

Um eine hohe Dynamik zu erreichen, werden bevorzugt in Piezotechnologie gefertigte Ventile oder mikromechanische Ventile aus Silizium verwendet.

Bei einer Weiterbildung des Pick and Place Systems wird die Lage der Unterkante des aufgenommenen Halbleiterchips mittels einer am Bondkopf angeordneten Lichtschranke gemessen. Der Lichtstrahl der Lichtschranke verläuft in horizontaler Richtung. Die Lichtschranke liefert ein binäres Signal, das angibt ob der Lichtstrahl unterbrochen ist oder nicht. Während des Pickens des Halbleiterchips ist der Chipgreifer abgesenkt und daher der Lichtstrahl unterbrochen. Nach dem Picken des Halbleiterchips wird der Chipgreifer angehoben und zwar soweit, dass der Lichtstrahl nicht mehr unterbrochen ist. Im Moment, wo das binäre Ausgangssignal der Lichtschranke von "unterbrochen" zu "nicht unterbrochen" wechselt, wird der Wert des Wegaufnehmers abgefragt. Somit ist es möglich, den Halbleiterchip auf eine von seiner Dicke abhängige Höhe abzusenken.

Nachfolgend werden Ausführungsbeispiele der Erfindung anhand der Zeichnung näher erläutert.

Es zeigen:
- Fig. 1: schematisch und in Aufsicht einen Die Bonder,
- Fig. 2: ein erstes Ausführungsbeispiel eines erfindungsgemässen Pick and Place Systems,
- Fig. 3: einen Pickprozess,
- Fig. 4: ein Ventilsystem und einen Regler,
- Fig. 5: einen Bondkopf mit einer Lichtschranke, und
- Fig. 6: ein weiteres Ausführungsbeispiel eines erfindungsgemässen Pick and Place Systems.

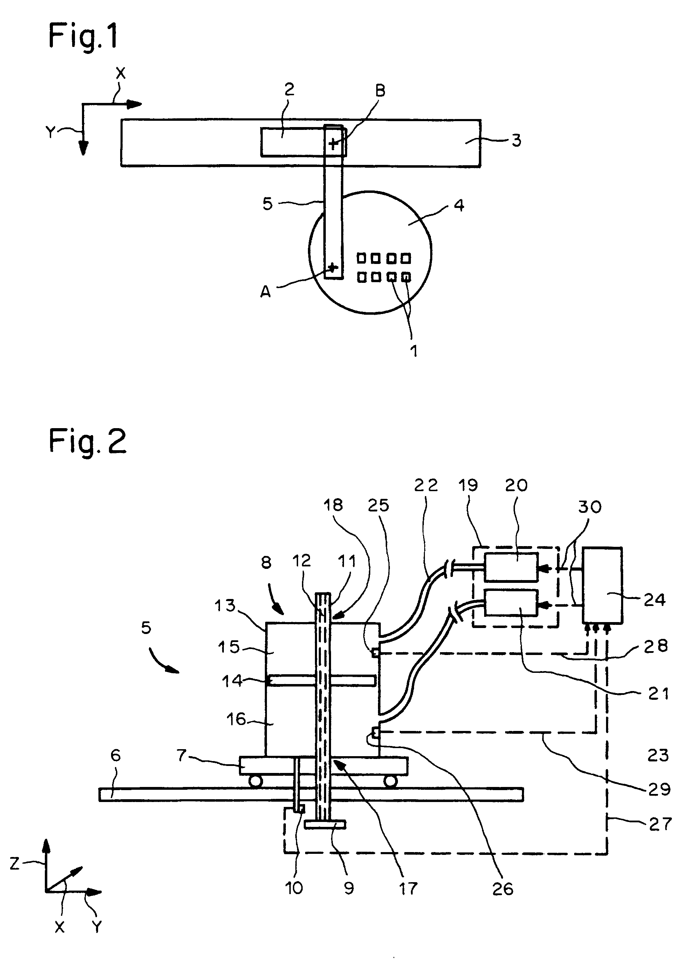

Die Fig. 1 zeigt schematisch und in Aufsicht einen Die Bonder für die Plazierung von Halbleiterchips 1 auf einem Substrat 2. Mit x, y und z sind die drei Koordinatenachsen eines kartesischen Koordinatensystems bezeichnet, wobei die z-Achse der vertikalen Richtung entspricht. Der Die Bonder umfasst ein Transportsystem 3 für den Transport des Substrats in x-Richtung und, fakultativ, auch in y-Richtung. Ein geeignetes Transportsystem 3 ist z.B. im europäischen Patent EP 330 831 beschrieben. Die Halbleiterchips 1 werden vorzugsweise von einem Wafertisch 4 nacheinander an einem Ort A bereitgestellt. Ein Pick and Place System5 entnimmt den Halbleiterchip 1 am Ort A und transportiert ihn zu einem Ort B über dem Substrat 2.

Die Fig. 2 zeigt ein erstes Ausführungsbeispiel des Pick and Place Systems 5. Das Pick and Place System 5 weist eine Linearführung 6 für die Führung eines Bondkopfs 7 in der y-Richtung auf. Die Linearführung 6 ist bezüglich der vertikalen z-Richtung ortsfest angeordnet, d.h. sie ist in z-Richtung nicht hebund senkbar. Ein nicht dargestellter Antrieb bewegt den Bondkopf 7 auf der Linearführung 6 in y-Richtung hin- und her. Die Linearführung 6 ist, fakultativ, mittels eines Antriebes in x-Richtung verschiebbar, um einen allfälligen Lagefehler des zu montierenden Halbleiterchips in x-Richtung innerhalb eines Bereiches von typisch ± 1.5 mm korrigieren zu können. Eine geeignete Linearführung 6 ist z.B. aus der europäischen Patentanmeldung EP 923 111 oder aus der europäischen Patentanmeldung EP 1 143 487 bekannt, nur ist sie im vorliegenden Fall bezüglich der z-Richtung ortsfest auszubilden.

Der Bondkopf 7 umfasst einen in z-Richtung, d.h. in vertikaler Richtung, auslenkbaren, von einem pneumatischen Antrieb 8 angetriebenen Chipgreifer 9 und einen Wegaufnehmer 10 für die Messung der Auslenkung des Chipgreifers 9 bezüglich des Bondkopfes 7 in z-Richtung. Der Hub, d.h. die maximale Auslenkung, des Chipgreifers 9 soll so klein wie möglich gehalten werden. Die z-Höhe des Wafertischs 4 ist deshalb so eingestellt, dass die Halbleiterchips 1 auf der gleichen z-Höhe gepickt werden, wie sie auf dem Substrat 2 plaziert werden. Auf diese Weise ist ein Hub von nur etwa 5 mm erreichbar. Bei Spezialanwendungen, beispielsweise dort, wo sich das Substrat 2 innerhalb eines Ofens befindet, ist der Hub grösser und kann bis zu 20 mm betragen. Der Chipgreifer 9 umfasst eine Stange 11, an deren unterem Ende ein den Halbleiterchips 1 angepasstes Pick-up Tool auswechselbar befestigt ist. Die Stange 11 weist eine mit Vakuum zum Halten des Halbleiterchips 1 beaufschlagbare Längsbohrung 12 auf. Der pneumatische Antrieb 8 besteht aus einem zylinderförmigen, auf dem Bondkopf 7 befestigten Gehäuse 13 mit zwei durch einen Kolben 14 getrennten Druckkammern 15 und 16. Die Stange 11 des Chipgreifers 9 ist in Bohrungen 17 und 18 des Gehäuses 13 gelagert und am Kolben 14 befestigt, so dass sie sich mit dem Kolben 14 in z-Richtung mitbewegt. Die Steuerung des in der ersten Druckkammer 15 herrschenden Druckes p₁ und des in der zweiten Druckkammer 16 herrschenden Druckes p₂ erfolgt mittels eines Ventilsystems 19, das beispielsweise aus zwei 2-Kanten-Ventilen 20 und 21 besteht. Die erste Druckkammer 15 ist über eine Leitung 22 mit dem ersten 2-Kanten-Ventil 20 verbunden, die zweite Druckkammer 16 ist über eine Leitung 23 mit dem zweiten 2-Kanten-Ventil 21 verbunden. Beide 2-Kanten-Ventile weisen je einen Eingang auf, dem Druckluft zugeführt wird, und je einen Eingang, dem Umgebungsluft oder Vakuum zugeführt wird, sowie einen Ausgang, an den die Leitung 22 bzw. 23 angeschlossen ist. Das aus den beiden Ventilen 20 und 21 bestehende Ventilsystem 19 wird von einem Regler 24 gesteuert. Ein erster Drucksensor 25 dient zur Messung des in der ersten Druckkammer 15 herrschenden Druckes p₁, ein zweiter Drucksensor 26 dient zur Messung des in der zweiten Druckkammer 16 herrschenden Druckes p₂. Die Ausgangssignale 27, 28 und 29 des Wegaufnehmers 10 bzw. der beiden Drucksensoren 25 und 26 werden dem Regler 24 als Eingangsgrössen zugeführt. Der Regler 24 liefert Steuersignale 30 für die Steuerung des Ventilsystems 19, im Beispiel also zwei Steuersignale 30 für die Steuerung der beiden 2-Kanten-Ventile 20 und 21.

Ein solches 2-Kanten-Ventil kann z.B. aus zwei getrennten Ventilen bestehen, deren Ausgänge verbunden sind und zusammen den Ausgang des 2-Kanten-Ventils bilden. In diesem Fall liefert der Regler 24 vier Steuersignale 30 für die Steuerung der vier Ventile.

Die Ventile 20 und 21 sind entweder auf dem Bondkopf 7 angeordnet und bewegen sich mit dem Bondkopf 7 mit, oder sie sind wie dargestellt stationär angeordnet.

Die Druckdifferenz p₁-p₂ erzeugt eine zur Querschnittsfläche des Kolbens 14 proportionale Kraft, die auf den Kolben 14 einwirkt und somit die Bewegung und Auslenkung des Chipgreifers 9 bewirkt. Über das erste 2-Kanten-Ventil 20 kann der ersten Druckkammer 15 entweder Druckluft zugeführt werden, um den Druck p₁ in der ersten Druckkammer 15 zu erhöhen, oder es kann die erste Druckkammer 15 entlüftet werden, um den Druck p₁ zu senken. Das Analoge gilt für das zweite 2-Kanten-Ventil 21 und die zweite Druckkammer 16.

Der Regler 24 arbeitet in zwei Betriebsarten. In der ersten Betriebsart wird die Auslenkung des Chipgreifers 9, also die z-Position, oder eine davon abgeleitete Grösse geregelt. Der Wegaufnehmer 10 erfasst kontinuierlich die Auslenkung zᵢₛₜ(t) in Funktion der Zeit t und der Regler 24 steuert die 2-Kanten-Ventile 20 und 21 gemäss einem vorgegebenen Verlauf zₛₒₗₗ(t). In der zweiten Betriebsart wird die Druckdifferenz p₁-p₂ geregelt, die die vom Chipgreifer 9 aufzubringende Bondkraft erzeugt. Dem gewünschten Pick- oder Place Prozess angepasst, werden dem Regler 24 zusätzlich Randbedingungen vorgegeben, besonders solche, die den Übergang von der ersten Betriebsart in die zweite Betriebsart betreffen. Im folgenden werden beispielhaft einige Prozesse beschrieben.

### 1. Absenken des Chipgreifers zur Aufnahme eines Halbleiterchips vom Wafertisch

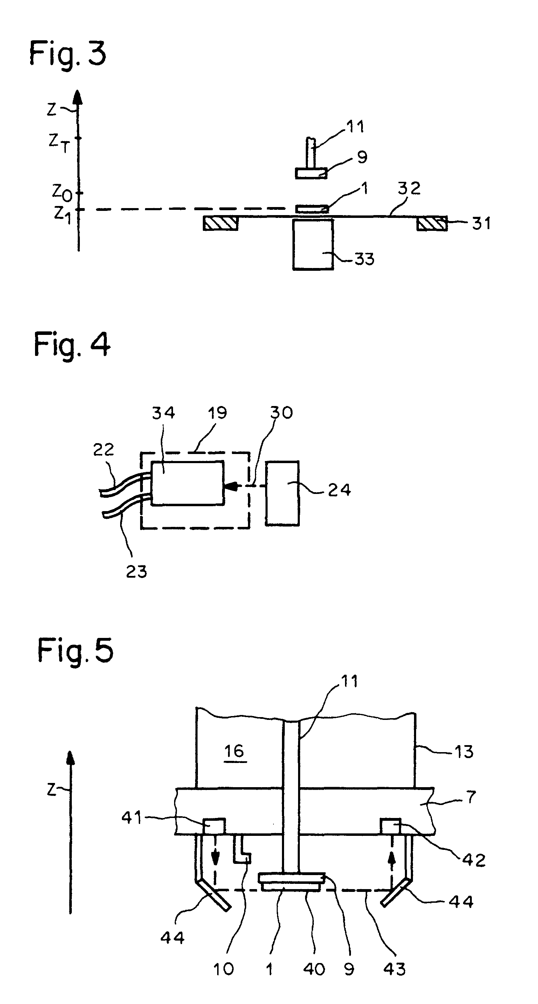

Das Absenken des Chipgreifers 9 erfolgt in drei Phasen und wird anhand der Fig. 3 erläutert. Der Halbleiterchip 1 haftet auf einer von einem Rahmen 31 gehaltenen Folie 32. Der Rahmen 31 ist auf dem Wafertisch 4 (Fig. 1) befestigt. Unterhalb des abzuarbeitenden Halbleiterchips 1 befindet sich ein sogenannter Die-Ejector 33, der den Pickprozess unterstützt. Die z-Koordinate bezeichnet die vom Wegaufnehmer 10 bezüglich des Bondkopfes 7 gemessene Auslenkung des Chipgreifers 9. In der ersten Phase wird der Chipgreifer 9 mit möglichst grosser Geschwindigkeit bis auf eine vorbestimmte Höhe z₀ abgesenkt. Die Höhe z₀ ist so bestimmt, dass der Chipgreifer 9 den aufzunehmenden Halbleiterchip 1 noch nicht berührt. Dabei ist zu beachten, dass die Höhe z₁ der dem Chipgreifer 9 zugewandten Oberfläche der Halbleiterchips 1 gewissen, wenn auch geringen, Schwankungen unterliegt. Während der zweiten Phase, die beim Durchfahren der Höhe z₀ beginnt, wird der Chipgreifer 9 mit einer konstanten Geschwindigkeit v₁ abgesenkt mit dem Ziel, den Aufprall des Chipgreifers 9 auf den Halbleiterchip 1 innerhalb kontrollierter Grenzen zu halten. Der Aufprall soll einerseits klein sein, was eine kleine Geschwindigkeit erfordert, andererseits soll der Entnahmeprozess nicht zu lange dauern, was gegen eine kleine Geschwindigkeit spricht. Die Geschwindigkeit v₁ ist dementsprechend zu bestimmen. Die Regelung der z-Position erfolgt in der ersten Phase also mit der Randbedingung, dass der Chipgreifer 9 beim Erreichen der Höhe z₀ bereits die Geschwindigkeit v₁ und eine verschwindende Beschleunigung aufweist. Wenn der Chipgreifer 9 mit dem Halbleiterchip 1 in Berührung kommt, dann setzt der Halbleiterchip 1 dem Absenken des Chipgreifers 9 Widerstand entgegen. Demzufolge wird in beiden Druckkammern 15 und 16 ein Druckimpuls erzeugt, der sich als Touchdown mittels der beiden Drucksensoren 25 und 26 detektieren lässt. Mit der Detektion des Touchdowns beginnt die dritte Phase: Der Regler 24 wechselt in die zweite Betriebsart und baut den der Kraft entsprechenden Differenzdruck auf, mit der der Halbleiterchip 1 beim Picken beaufschlagt werden soll.

Beim Picken muss sich der Halbleiterchip 1 von der Folie 32 lösen. Das Ablösen kann auf verschiedene Arten unterstützt werden. Verbreitet ist das Ablösen mittels einer Nadel, die die Folie 32 von der Unterseite her durchstösst und den Halbleiterchip 1 etwas anhebt, so dass sich die Folie 32 vom Halbleiterchip 1 löst. Bei diesem Prozess ändern sich zwar die Volumina der beiden Druckkammern 15 und 16, die Druckdifferenz p₁-p₂ wird vom Regler 24 aber konstant gehalten. Bekannt ist aber auch das Ablösen der Folie 32 ohne Hilfe einer Nadel, in dem die Folie mittels Vakuum von der Unterseite des Halbleiterchips 1 weggezogen wird.

Sobald die Ablösung der Folie vom Halbleiterchip 1 ausreichend weit abgeschlossen ist, wechselt der Regler 24 wieder in die erste Betriebsart, um den Chipgreifer 9 in möglichst kurzer Zeit auf eine vorbestimmte Höhe z_{T} anzuheben.

### 2. Plazieren eines relativ grossen Halbleiterchips auf dem Substrat

Das Absenken des Chipgreifers 9 erfolgt in zwei Phasen. In der ersten Phase wird der Chipgreifer 9 in möglichst kurzer Zeit bis auf eine vorbestimmte Höhe z₂ abgesenkt. Der Regler 24 befindet sich dabei in der ersten Betriebsart, in der er die Auslenkung z(t) regelt. Beim Erreichen der Höhe z₂ wird der Regler 24 in die zweite Betriebsart umgeschaltet, in der er die aufzubringende Bondkraft aufbaut und regelt. Um einen fliessenden Übergang von der Positionsregelung zur Bondkraftregelung zu erreichen, werden die Regelparameter in der ersten Phase soweit möglich so vorgegeben, dass beim Erreichen der Höhe z₂ der der aufzubringenden Bondkraft entsprechende Differenzdruck p₁-p₂ erreicht ist.

### 3. Plazieren eines relativ kleinen Halbleiterchips auf dem Substrat

Bei kleinen Halbleiterchips wird eine kleine Bondkraft benötigt, die sogar unterhalb des Eigengewichts des Chipgreifers 9 liegen kann. Das Absenken des Chipgreifers 9 erfolgt wiederum in zwei Phasen. In der ersten Phase wird der Chipgreifer 9 in möglichst kurzer Zeit bis auf eine vorbestimmte Höhe z₂ abgesenkt. Die Regelparameter sind so vorgegeben, dass beim Durchfahren der Höhe z₂ erstens die Geschwindigkeit des Chipgreifers 9 einen vorbestimmten Wert aufweist und zweitens die Druckdifferenz p₁-p₂ eine winzige Kraft von beispielsweise nur noch 0.03 N erzeugt. Die zweite Phase beginnt mit dem Erreichen der Höhe z₂ und endet eine vorbestimmte Zeitspanne τ später, wenn der Chipgreifer 9 abgehoben wird. Während der zweiten Phase fällt der Chipgreifer 9 mit dem Halbleiterchip 1 zunächst in der Luft, bis er auf den Klebstoff auftrifft, und sinkt danach weiter ab, bis der Chipgreifer 9 am Ende der zweiten Phase angehoben wird. Das Vakuum an der Spitze des Chipgreifers 9 muss rechtzeitig gelöst werden, damit der Halbleiterchip 1 beim Abheben des Chipgreifers 9 auf dem Klebstoff zurückbleibt. Die Höhe z₂ ist so vorbestimmt, dass der Halbleiterchip 1 in der zweiten Phase noch etwa 0.5 mm zurücklegt.

Die beschriebenen Prozesse für das Aufnehmen und Absetzen der Halbleiterchips sind als Ausführungsbeispiele zu verstehen, die den Betrieb des erfindungsgemässen Pick and Place Systems und die erzielten Vorteile veranschaulichen sollen. Mit diesem Pick and Place System lassen sich aber auch andere Prozesse durchführen, bei denen die Aufnahme und Plazierung der Halbleiterchips noch weiter optimiert ist.

Als Ventile werden vorteilhaft Proportionalventile verwendet. Da die Bewegung des Chipgreifers 9 mit hoher Dynamik erfolgen muss, müssen die Proportionalventile in der Lage sein, vom Steuersignal des Reglers 24 vorgegebenen Änderungen zu folgen, auch wenn das Frequenzspektrum des Steuersignals Anteile im Bereich oberhalb von 100 Hz, typisch bis zu 300 Hz aufweist. Diese Anforderung wird z.B. von Proportionalventilen erfüllt, die auf der Piezotechnologie basieren.

Die Beschleunigung des Chipgreifers 9 bzw. des Kolbens 14 ist proportional zur Druckdifferenz p₁-p₂. Um den Chipgreifer 9 aus der Transporthöhe z_{T} auf die Höhe z₀ abzusenken, muss entweder der Druck p₁ in der ersten Kammer 15 erhöht oder der Druck p₂ in der zweiten Kammer 16 erniedrigt werden. Damit das Absenken möglichst schnell erfolgen kann, ist es vorteilhaft, gleichzeitig den Druck p₁ zu erhöhen und den Druck p₂ zu erniedrigen. Da die Druckerniedrigung zudem langsamer erfolgt als der Druckaufbau, ist es vorteilhaft, die beiden Druckkammern 15 und 16 auf einem hohen Druckniveau zu betreiben. D.h. bei einer Speisung der Ventile mit 4 bar betragen der Druck p₁ und der Druck p₂ im Ruhezustand des Kolbens 14 typisch etwa 3 bis 3.5 bar.

Der Regler 24 ist daher mit Vorteil so eingestellt, dass er
- die beiden Druckkammern 15 und 16 auf einem möglichst hohen Druckniveau betreibt;
- für eine Erhöhung des Differenzdruckes p₁-p₂ soweit möglich gleichzeitig den Druck p₁ erhöht und den Druck p₂ erniedrigt;
- für eine Erniedrigung des Differenzdruckes p₁-p₂ soweit möglich gleichzeitig den Druck p₁ erniedrigt und den Druck p₂ erhöht; und
- beim positionsgeregelten Anfahren einer vorbestimmten Position z₀ den Differenzdruck p₁-p₂ so regelt, dass beim Erreichen der Auslenkung z₀, wo dann von der Positionsregelung auf die Druckdifferenzregelung umgeschaltet wird, die erforderliche Druckdifferenz erreicht ist.

Vorteilhaft ist es, wenn beide Druckkammern 15 und 16 dynamisch geregelt werden. Es ist aber auch möglich, den Druck in einer der beiden Druckkammern 15 oder 16 konstant zu halten und nur den Druck in der anderen der beiden Druckkammern 15 oder 16 dynamisch zu regeln.

Die Fig. 4 zeigt ein Ventilsystem 19, das aus einem einzigen Vier-Kanten-Ventil 34 besteht, und den Regler 24. Das Vier-Kanten-Ventil 34 weist einen Eingang auf, dem Druckluft zugeführt wird, und einen Eingang, dem Umgebungsluft oder Vakuum zugeführt wird, sowie zwei Ausgänge, an die die Leitungen 22 bzw. 23 angeschlossen sind. Das Vier-Kanten-Ventil 34 ist beispielsweise ein Proportionalventil, bei dem ein einziger Kolben die an den Ausgängen herrschenden Drücke p₁' und p₂' steuert: Die Drücke p₁' und p₂' sind aneinander gekoppelt, und zwar derart, dass der Druck p₂' am zweiten Ausgang abnimmt, wenn der Druck p₁' am ersten Ausgang zunimmt. Für die Regelung der mit den Drucksensoren 25 und 26 gemessenen Drücke p₁ bzw. p₂ muss der Regler 24 deshalb nur ein einziges Steuersignal erzeugen.

Da das Pick and Place System 5 nur eine einzige bewegliche z-Achse aufweist, ergibt sich die Möglichkeit, die z-Höhe der Unterkante 40 des aufgenommenen Halbleiterchips 1 auf einfache Weise, beispielsweise mittels einer Lichtschranke zu messen. Die Fig. 5 zeigt einen Ausschnitt des mit einer Lichtschranke erweiterten Bondkopfs 7. Die Lichtschranke umfasst einen Lichtsender 41, z.B. eine Leuchtdiode oder eine Laserdiode, und einen Lichtempfänger 42. Der Lichtstrahl 43 der Lichtschranke verläuft in horizontaler Richtung. Aus konstruktiven Gründen ist es vorteilhaft, den Lichtsender 41 und den Lichtempfänger 42 so am Bondkopf 7 anzuordnen, dass der Lichtsender 41 einen Lichtstrahl 43 in vertikaler Richtung aussendet und der Lichtempfänger 42 in z-Richtung sich ausbreitendes Licht detektiert, und den Lichtstrahl 43 mittels zweier Umlenkspiegel 44 oder Prismen in die horizontale Richtung umzulenken. Die Lichtschranke liefert ein binäres Signal, das angibt ob der Lichtstrahl 43 unterbrochen ist oder nicht.

Während der Hin- und Her Bewegung des Bondkopfes vom Ort A zum Ort B befindet sich der Chipgreifer 9 in einer angehobenen Position oberhalb des Lichtstrahls 43. Zum Aufnehmen des auf dem Wafertisch 4 (Fig. 1) bereitgestellten Halbleiterchips 1 wird der Chipgreifer 9 abgesenkt, wobei er den Lichtstrahl 43 unterbricht. In dem Moment, wo das Signal der Lichtschranke von "nicht unterbrochen" zu "unterbrochen" wechselt, wird der Wert W₁ des vom Wegaufnehmer 10 gelieferten Signals abgefragt.

Nach dem Picken des Halbleiterchips 1 wird der Chipgreifer 9 angehoben. In dem Moment, wo das Signal der Lichtschranke von "unterbrochen" zu "nicht unterbrochen" wechselt, wird der Wert W₂ des vom Wegaufnehmer 10 gelieferten Signals abgefragt. Dieser zweite Wert W₂ ist ein Mass für die z-Höhe der Unterkante 40 des aufgenommenen Halbleiterchips 1. Falls sich die Werte W₁ und W₂ nicht um mehr als einen vorgegebenen Toleranzwert unterscheiden, bedeutet dies, dass das Picken fehlgeschlagen ist und dass kein Halbleiterchip am Chipgreifer 9 haftet. In diesem Fall wird das Picken wiederholt und/oder eine Warn- oder Alarmmeldung erzeugt.

Mit diesem Messsystem ist ein weiterer Prozess möglich, um den Halbleiterchip 1 auf dem Substrat 2 zu plazieren: Der Chipgreifer 9 wird auf eine vom gemessenen Wert W₂ abhängige z-Höhe abgesenkt, nämlich auf die Höhe z₂ = z₂' + Wₛₒₗₗ - W₂, wobei die Höhe z₂' einen konstanten Wert und Wₛₒₗₗ einen konstanten Referenzwert für die Soll-Dicke des Halbleiterchips 1 bezeichnen. Nachdem die Höhe z₂ erreicht ist, wird der Chipgreifer 9 wieder angehoben. Bei diesem Prozess wird der Regler 24 beim Plazieren des Halbleiterchips 1 also nur in der ersten Betriebsart betrieben, in der die z-Höhe geregelt wird. Kleine Halbleiterchips können mit der von der Konstruktion erlaubten Maximalgeschwindigkeit auf dem Klebstoff auf dem Substrat abgesetzt werden. Relativ grosse Halbleiterchips hingegen müssen etwas langsamer plaziert werden, da sicherzustellen ist, dass der Klebstoff sich unter dem Halbleiterchip gleichmässig und ohne Bildung von Lufteinschlüssen verteilen kann.

Falls auch Schwankungen in der Dicke des Substrats 2 nicht vernachlässigbar sind, dann ist mit Vorteil ein weiteres Messsystem vorhanden, um die Dicke D des Substrats 2 zu messen. Beim Plazieren des Halbleiterchips 1 wird der Chipgreifer 9 dann auf die Höhe z₂ = z₂' + Wₛₒₗₗ - W₂ +Dₛₒₗₗ - D abgesenkt, wobei die Grösse Dₛₒₗₗ den Sollwert der Substratdicke bezeichnet.

Änderungen des Wertes W₁ weisen auf Abnutzungen des Pick-up Tools hin. Somit kann durch Verfolgen des Wertes W₁ die Abnutzung des Pick-up Tools überwacht und bei Überschreitung eines vorgegebenen Wertes eine Warnmeldung erzeugt werden.

Im folgenden werden noch andere Ausführungsarten des Pick and Place Systems 5 beschrieben. Die Ausführung des pneumatischen Antriebes 8, der Ventile 20, 21 oder 34 und des Reglers 24 sind dabei wie vorstehend beschrieben.

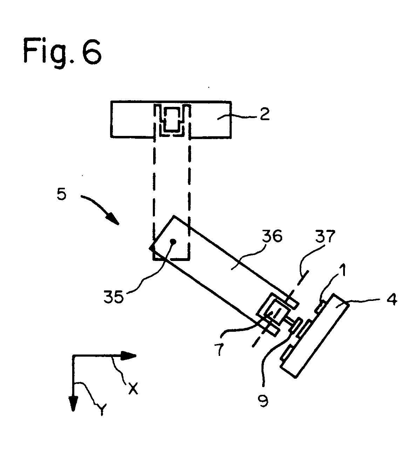

Die Fig. 6 zeigt in Aufsicht ein Ausführungsbeispiel, bei dem das Pick and Place System 5 einen um eine vertikale Achse 35 zwischen zwei Endlagen hin und her schwenkbaren Schwenkarm 36 aufweist, an dessen einem Ende der Bondkopf 7 angeordnet ist. Der Schwenkarm 36 dient zur Führung des Bondkopfes 7 in der xy-Ebene. Der mit einer ausgezogenen Linie dargestellte Schwenkarms 36 befindet sich in der ersten Endlage. Mit einer gestrichelten Linie ist die zweite Endlage des Schwenkarms 36 dargestellt. Der Schwenkarm 36 ist in der vertikalen z-Richtung nicht heb- und senkbar. Die z-Höhe des Chipgreifers 9 kann also nur mittels des auf dem Bondkopf 7 angeordneten pneumatischen Antriebes 8 (Fig. 2) verstellt werden.

Bei einer ersten Variante werden die Halbleiterchips 1 auf einem senkrecht angeordneten Wafertisch 4 bereitgestellt und wie üblich auf einem waagrecht bereitgestellten Substrat 2 plaziert. Der Bondkopf 7 ist deshalb um eine horizontale Achse 37 um 90° drehbar. Zum Picken des bereitgestellten Halbleiterchips 1 wird der Schwenkarm 36 in die erste Endlage geschwenkt und der Bondkopf 7 um die Achse 37 gedreht, so dass der Chipgreifer 9 durch Betätigung des pneumatischen Antriebes 8 in horizontaler Richtung ausgelenkt werden kann, um den bereitgestellten Halbleiterchip 1 aufzunehmen. Nach der Aufnahme des Halbleiterchips 1 wird der Schwenkarm 36 in die andere Endlage geschwenkt und der Bondkopf 7 um 90° um die Achse 37 gedreht, so dass der Chipgreifer 9 den Halbleiterchip 1 auf dem Substrat 2 absetzen kann.

Bei einer zweiten Variante werden die Halbleiterchips 1 auf einem waagrecht angeordneten Wafertisch 4 bereitgestellt. In diesem Fall entfallen die Achse 37 und damit die Drehung des Bondkopfes 7 um die Achse 37.

Für die Steuerung des Chipgreifers 9 zum Aufnehmen und Absetzen des Halbleiterchips 1 können beispielsweise die Prozesse benützt werden, die oben beschrieben wurden.

## Patentansprüche

1. Einrichtung für die Montage von Halbleiterchips, mit einem Pick and Place System (5) für die Aufnahme, den Transport und das Absetzen eines Halbleiterchips (1) auf einem Substrat (2), wobei das Pick and Place System (5) einen Bondkopf (7) mit einem Chipgreifer (9) aufweist, wobei der Chipgreifer (9) gegenüber dem Bondkopf (7) auslenkbar ist, **dadurch gekennzeichnet, dass** der Bondkopf (7) einen aus zwei durch einen Kolben (14) getrennten Druckkammern (15, 16) gebildeten pneumatischen Antrieb (8) für die Auslenkung des Chipgreifers (9) aufweist, wobei der Chipgreifer (9) am Kolben (14) befestigt ist, wobei der in der ersten Druckkammer (15) herrschende Druck p₁ und der in der zweiten Druckkammer (16) herrschende Druck p₂ mittels eines Ventilsystems (19) gesteuert werden, dass der Bondkopf (7) einen Wegaufnehmer (10) für die Messung der Auslenkung des Chipgreifers (9) gegenüber dem Bondkopf (7) aufweist, dass ein erster Drucksensor (25) für die Messung des in der ersten Druckkammer (15) herrschenden Druckes p₁ und, fakultativ, ein zweiter Drucksensor (26) für die Messung des in der zweiten Druckkammer (16) herrschenden Druckes p₂ vorhanden sind, und dass ein in zwei Betriebsarten betreibbarer Regler (24) für die Steuerung des Ventilsystems (19) vorhanden ist, wobei in der ersten Betriebsart die Auslenkung des Chipgreifers (9) und/oder eine davon abgeleitete Grösse aufgrund des von dem Wegaufnehmer (10) gelieferten Signals geregelt wird und wobei in der zweiten Betriebsart der erste Druck p₁ und/oder der zweite Druck p₂ und/oder die Druckdifferenz p₁-p₂ geregelt wird.

2. Einrichtung nach Anspruch 1, **dadurch gekennzeichnet, dass** das Ventilsystem (19) in Piezotechnologie gefertigte Ventile (20, 21, 34) oder mikromechanische Ventile aus Silizium umfasst.

3. Einrichtung nach Anspruch 1 oder 2, **dadurch gekennzeichnet, dass** am Bondkopf (7) eine Lichtschranke angeordnet ist, um die Lage einer Unterkante (40) des aufgenommenen Halbleiterchips (1) zu ermitteln.

4. Einrichtung nach einem der Ansprüche 1 bis 3, **dadurch gekennzeichnet, dass** das Pick and Place System (5) eine bezüglich der Auslenkungsrichtung des Chipgreifers (9) stationär angeordnete Linearführung (6) für eine Hin und Her Bewegung des Bondkopfs (7) aufweist.

5. Einrichtung nach einem der Ansprüche 1 bis 3, **dadurch gekennzeichnet, dass** das Pick and Place System (5) einen um eine vertikale Achse (35) zwischen zwei Endlagen hin und her schwenkbaren, in vertikaler Richtung nicht beweglichen Schwenkarm (36) aufweist.

## Claims

1. Apparatus for mounting semiconductor chips, with a pick and place system (5) for the pick-up, transport and placement of a semiconductor chip (1) onto a substrate (2), whereby the pick and place system (5) has a bondhead (7) with a chip gripper (9), whereby the chip gripper (9) can be deflected in relation to the bondhead (7), **characterised in that** the bondhead (7) has a pneumatic drive (8) formed from two pressure chambers (15,16) separated by a piston (14) for deflection of the chip gripper (9), whereby the chip gripper (9) is secured to the piston (14), whereby the pressure p₁ prevailing in the first pressure chamber (15) and the pressure p₂ prevailing in the second pressure chamber (16) are controlled by means of a valve system (19), that the bondhead (7) has a position encoder (10) for measuring the deflection of the chip gripper (9) in relation to the bondhead (7), that a first pressure sensor (25) for measuring the pressure p₁ prevailing in the first pressure chamber (15) and, optionally, a second pressure sensor (26) for measuring the pressure p₂ prevailing in the second pressure chamber (16) are present, and that a regulator (24) operable in two operating modes is present for control of the valve system (19), whereby in the first operating mode the deflection of the chip gripper (9) and/or a variable derived from it is controlled based on the signal delivered by the position encoder (10) and whereby in the second operating mode the first pressure p₁ and/or the second pressure p₂ and/or the pressure differential p₁-p₂ is controlled.

2. Apparatus according to claim 1, **characterised in that** the valve system (19) comprises valves (20, 21, 34) produced with the piezo technology or micromechanical valves made of silicon.

3. Apparatus according to claim 1 or 2, **characterised in that** a light barrier is arranged on the bondhead (7) in order to determine the position of the lower edge (40) of the picked semiconductor chip (1).

4. Apparatus according to one of claims 1 to 3, **characterised in that** the pick and place system (5) has a linear guide (6) arranged stationary relative to the deflection direction of the chip gripper (9) for a back and forth movement of the bondhead (7).

5. Apparatus according to one of claims 1 to 3, **characterised in that** the pick and place system (5) has a swivel arm (36) which can be swivelled on a vertical axis (35) between two limit positions and which can not be moved in vertical direction.

## Revendications

1. Dispositif pour le montage de puces de semi-conducteurs avec un système de prise et de positionnement (5) pour la prise, le transport et la dépose d'une puce de semi-conducteur (1) sur un substrat (2), le système de prise et de positionnement (5) comportant une tête de soudeuse (7) avec un outil de prise de puces (9), lequel outil de prise de puces (9) peut être dévié par rapport à la tête de soudeuse (7), **caractérisé en ce que** la tête de soudeuse (7) présente pour la déviation de l'outil de prise de puces (9) un entraînement pneumatique (8) formé par deux chambres de pression (15, 16) séparées par un piston (14), l'outil de prise de puces (9) étant fixé sur le piston (14), la pression pi régnant dans la première chambre de pression (15) et la pression p₂ régnant dans la deuxième chambre de pression (16) étant régulées au moyen d'un système de soupapes (19), **en ce que** la tête de soudeuse (7) possède un capteur de déplacement (10) pour la mesure de la déviation de l'outil de prise de puces (9) par rapport à la tête de soudeuse (7), **en ce qu'**il est prévu un premier capteur de pression (25) pour la mesure de la pression p₁ régnant dans la première chambre de pression (15) et, facultativement, un deuxième capteur de pression (26) pour la mesure de la pression p₂ régnant dans la deuxième chambre de pression (16), et en qu'un régulateur (24) pouvant fonctionner dans deux modes de fonctionnement est prévu pour la commande du système de soupapes (19), la déviation de l'outil de prise de puces (9) et/ou une grandeur dérivée de celle-ci étant régulées dans le premier mode de fonctionnement sur la base du signal fourni par le capteur de déplacement (10) et la première pression p₁ et/ou la deuxième pression p₂ et/ou la différence de pression p₁-p₂ étant régulées dans le second mode de fonctionnement.

2. Dispositif selon la revendication 1, **caractérisé en ce que** le système de soupapes (19) comprend des soupapes (20, 21, 34) fabriquées selon une technologie piézoélectrique ou des soupapes micromécaniques en silicium.

3. Dispositif selon la revendication 1 ou 2, **caractérisé en ce qu'**il est prévu sur la tête de soudeuse (7) un barrage photoélectrique destiné à déterminer la position d'un bord inférieur (40) de la puce de semi-conducteur (1) saisie.

4. Dispositif selon l'une quelconque des revendications 1 à 3, **caractérisé en ce que** le système de prise et de positionnement (5) présente un guidage linéaire (6) disposé de façon stationnaire par rapport à la direction de déviation de l'outil de prise de puces (9) pour le déplacement en va-et-vient de la tête de soudeuse (7).

5. Dispositif selon l'une quelconque des revendications 1 à 3, **caractérisé en ce que** le système de prise et de positionnement (5) présente un bras pivotant (36) qui peut pivoter en va-et-vient entre deux oppositions de fin de course autour d'un axe vertical (35) et qui n'est pas mobile dans le sens vertical.
